# EUROPEAN PATENT SPECIFICATION

(11) **EP 3 897 086 B1**
(45) Date of publication and mention of the grant of the patent: **05.04.2023**
(21) Application number: 20169348.8
(22) Date of filing: 14.04.2020
(51) Int. Cl.: H05K 9/00, H02G 3/06

(54) **CABLE BUSHING**
KABELBUCHSE
TRAVERSÉE DE CÂBLE

(43) Date of publication of application: 20.10.2021
(73) Proprietor: Stassinopoulos, Michael, 151 25 Maroussi, Attica (GR)
(72) Inventor: Stassinopoulos, Michael, 151 25 Maroussi, Attica (GR)
(74) Representative: TBK

(56) References cited:
- EP-A2- 0 058 876
- WO-A1-2018/193420
- JP-A- 2002 199 555
- US-A- 4 640 569
- US-A- 4 960 392
- US-A- 5 691 506

## Description

### Field

The present disclosure relates to a cable bushing for guiding a shielded cable through a wall, a method of mounting a cable bushing to a cable, and an electromagnetic shielding system. Particularly, the disclosure relates to a cable bushing, which improves a protection of an electric signal inside the cable, a corresponding method of mounting the cable bushing to a cable, and an electromagnetic shielding system comprising the cable bushing.

### Background

Cable bushings for guiding a shielded cable through a wall, such as a wall of a housing or a box, are conventionally known. Conventionally, when guiding a cable through the wall, a conventional cable bushing is mounted to the cable before inserting the cable bushing with the cable into an aperture of the wall.

When mounting the conventional cable bushing to the cable, the cable needs to be inserted into a hole formed in the conventional cable bushing. This includes a process of threading the cable through the hole of the conventional cable bushing, until the cable is positioned at a desired position in its length direction with respect to the cable bushing. This may cause a hassle when mounting the conventional cable bushing to the cable, especially if the cable length is relatively long, such that a significant length of the cable needs to be threaded through the hole of the conventional cable bushing.

Furthermore, a cable bushing shall provide a reliable protection of an electric signal inside the cable, particularly from electromagnetic radiation to which the cable and the cable bushing might be exposed.

EP 0 058 876 A2 discloses a cable fitting piece according to the preamble of claim 1. WO 2018 / 193 420 A1, US4640569A, US 5 691 506 A1, and JP 2002 - 199 555 A disclose further prior art.

Therefore, it is an object of the present disclosure to provide a cable bushing for guiding a cable through a wall, a method of mounting a cable bushing to a cable, and an electromagnetic shielding system, which allow protection of the electric signal inside the cable and permit a simple mounting procedure of the cable bushing to the cable.

### Summary

The object is solved by a cable bushing according to claim 1. The cable bushing for guiding a cable through a wall comprises a first bushing body, a first metal member arranged in the first bushing body, and a second bushing body attachable to the first bushing body for pressing the cable against the first bushing body. The first bushing body and the second bushing body are made from a non-metal material, and the first metal member is suitable for establishing an electrical connection between a cable shield of the cable and the wall.

The cable bushing is suitable for guiding a cable through the wall such as a wall of housing, a box or the like. The first metal member may be made from a metal like steel, copper, aluminum, brass, or the like, which have an electric conductivity. Further, the first metal member may also be made of a metal composite material having an electric conductivity. Moreover, the metal material of the first metal member may be selected in accordance with the material of the wall and the materials of the cable in order to prevent galvanic corrosion.

The second bushing body is attachable to the first bushing body via a suitable attachment such as a pin-and-hole connection, and snap connection, or the like. Preferably, the second bushing body is attachable to the first bushing body in a detachable manner. The first bushing body is configured to accommodate a cable therein and the second bushing body is configured to press the cable against the first bushing body. Thereby, the cable is fixed in its position and a relative movement between the cable and the first bushing body is prevented. Particularly, a pull-out of the cable in its length direction from the cable bushing is prevented, when the second bushing body is attached to the first bushing body.

The first bushing body and the second bushing body are made from a non-metal material such as resin, plastic, etc., thereby allowing a simplified manufacturing of the cable bushing and reduced manufacturing cost. Particularly, the first bushing body and the second bushing body may be made of an electric insulating material in order to prevent unintentional electric contact between a portion of the cable and other elements surrounding the cable bushing.

The first metal member is suitable for establishing an electrical connection between a cable shield of the cable and the wall. The cable shield refers to e.g. a wire or wire mesh underneath an insulation layer of the cable. Thereby the cable shield of the cable is electrically connected to the wall via the first metal member so as to have a common ground (electrical grounding). That is, the members have a common electrical potential. Thereby a signal transferred in a core of the cable is protected from electromagnetic radiation, and the impact of the electromagnetic radiation is reduced by electrically connecting the cable shield to the wall as a common ground.

Electromagnetic radiation particularly refers to mobile radio communication. Mobile radio communication may be particularly transmitted by an electromagnetic transmitting and/or receiving device, such as a mobile phone, a mobile phone base station, a digital wireless systems, a wireless internet gateway, a laptop, or similar devices. Electromagnetic radiation may particularly refer to signals emitted in the frequency range of at least 900 MHz to 1800 MHz (GSM), 800 MHz to 1800 MHz (LTE), 600 MHz to 6 GHz (5G), or 2.4 GHz to 5 GHz (Wifi), up to 10 GHz.

Furthermore, an electric device which is protected by the wall and which has a cable guided through the wall can be effectively protected from electromagnetic radiation by electrically connecting the cable shield of the cable to the wall via the cable bushing. Thereby, interference can be effectively attenuated.

The electric connection between the cable shield and the first metal member may be established by stripping off a portion of an outer layer of the cable (cable sheathing) such that a portion of the cable shield underneath the outer layer is exposed to the outside, and placing the cable on the first bushing body such that the exposed portion of the cable shield abuts against the first metal member.

The cable bushing further comprises a second metal member arranged in the second bushing body, and the second metal member is suitable for establishing an electric connection between the cable shield of the cable and the wall.

The provision of the second metal member improves the electric contact between the cable shield and the cable bushing such that the electric connection is more reliably established. Furthermore, the provision of the second metal member further reduces the impact of electromagnetic radiation by more extensively covering the aperture of the wall.

Preferably, the second metal member is electrically connectable to the first metal member by attaching the first bushing body to the second bushing body.

A configuration, in which the electric connection between the first metal member and the second metal member is established, simultaneously when the first bushing body is attached to the second bushing body, allows a simplified mounting procedure of the cable bushing to the cable. Particularly, there is no need to perform separate steps of establishing an electrical connection between the first metal member and the second metal member, and attaching the first bushing body to the second bushing body, because both steps are performed simultaneously in one attachment step.

In an embodiment, a through-hole for guiding the cable through the wall may be provided in the first bushing body and the second bushing body along a contact plane of the first bushing body and the second bushing body, when the second bushing body is attached to the first bushing body. In this embodiment, the first metal member and the second metal member may protrude into the through-hole for establishing an electrical connection with the cable shield.

According to this configuration, the first bushing body and the second bushing body are attachable along a contact plane between the first bushing body and the second bushing body. Thereby, the cylindrical through-hole is formed by two semi-cylindrical grooves, which are respectively formed in the first bushing body and the second bushing body. Such a two-piece configuration of the cable bushing allows an easy placement of the cable on the first bushing body and the first metal member, and then attaching the second bushing body and the second metal member from the side.

Moreover, by arranging the first metal member and the second metal member in the first bushing body and the second bushing body, respectively, such that the first metal member and the second metal member protrude radially inward into the through-hole, the electric contact between the cable shield and the first metal member and the second metal member is further improved.

Preferably, the cable bushing may be configured to clamp the cable between the first bushing body and the second bushing body by attaching the first bushing body to the second bushing body.

By configuring the cable bushing such that the cable is clamped between the first bushing body and the second bushing body, when the first bushing body is attached to the second bushing body, a further simplified mounting procedure of the cable bushing to the cable is provided. Particularly, there is no need for an additional step of fixing the cable to the first bushing body before attaching the second bushing body thereto. Thus, a simple configuration of the cable bushing is achieved, which reliably fixes the cable and effectively prevents pull-out of the cable in its length direction from the cable bushing.

The first bushing body comprises a first main portion and a first auxiliary portion arranged on an opposite side of the first metal member with respect to the first main portion, for holding the first metal member therebetween. Similarly, the second bushing body comprises a second main portion and a second auxiliary portion arranged on an opposite side of the second metal member with respect to the second main portion, for holding the second metal member therebetween.

In such a configuration, the first metal member and the second metal member are effectively held in the first bushing body and the second bushing body, respectively, by interposing them between the first main portion and the first auxiliary portion, and the second main portion and the second auxiliary portion, respectively, without additional fixing means.

Preferably, the first main portion and the second main portion may each have a semi-cylindrical shape, and the first metal member and the second metal member may each have a semi-circular disc shape. The first metal member may be arranged in the first bushing body such that a radius center point of the semi-circular shape of the first metal member is positioned on the cylinder axis of the semi-cylindrical shape of the first main portion, and the second metal member may be arranged in the second bushing body such that a radius center point of the semi-circular shape of the second metal member is positioned on the cylinder axis of the semi-cylindrical shape of the second main portion.

In such a configuration, the semi-cylindrical first main portion and the semi-cylindrical second main portion form a cylinder shape, when the first bushing body and the second bushing body are attached together. Thereby, the first main portion and the second main portion allow an easy insertion of the cable bushing into a cylindrical aperture in the wall.

Similarly, the semi-circular first metal member and the semi-circular second metal member form a circular disk shape, when the first bushing body is attached to the second bushing body. Thereby, the first metal member and the second metal member form a circular disc shape, which allows easy handling when inserting the cable bushing into a hole of the wall.

Moreover, when the second bushing body is attached to the first bushing body, the cylindrical shape formed by the first main portion and the second main portion is arranged concentrically to the circular disk shape formed by the first metal member and the second metal member.

In an embodiment, the semi-circular shape of the first metal member may have an outer radius larger than an outer radius of the semi-cylindrical shape of the first main portion of the first bushing body. Similarly, the semi-circular shape of the second metal member may have an outer radius larger than an outer radius of the semi-cylindrical shape of the second main portion of the second bushing body.

Such a configuration ensures that the first metal member and the second metal member protrude from the first bushing body and the second bushing body radially outward. Thereby, the first metal member and the second metal member serve as a stopper for stopping the cable bushing at a predetermined position, when the cable bushing is inserted into the wall.

Moreover, it is ensured that the first metal member and the second metal member come into contact with the wall, when inserting the cable bushing into the wall. Thereby, the electrical contact between the first metal member and the second metal member and the wall is reliably established.

Preferably, the first main portion may have a recess on a surface facing the second main portion in an attachment direction of the first bushing body and the second bushing body. Similarly, the second main portion may have a recess on a surface facing the first main portion in an attachment direction of the first bushing body and the second bushing body.

In such a configuration, the recess in the first main portion has a semi-cylindrical shape and is positioned concentrically to the semi-cylindrical shape of the first main portion. Similarly, the recess in the second main portion has a semi-cylindrical shape and is positioned concentrically to the semi-cylindrical shape of the second main portion. In this configuration, the first main portion and the second main portion may each have a shape of a hollow semi-cylinder.

The recess enables a larger outer diameter of the cable bushing, which makes the cable bushing less flexible and more robust. Furthermore, the recess saves material volume needed for manufacturing the cable bushing and thus, the cable bushing has reduced material costs.

Preferably, the first main portion and the second main portion may each have axially extending protrusions for holding the cable therebetween in a state, in which the second bushing body is attached to the first bushing body. Similarly, the first auxiliary portion and the second auxiliary portion may each have axially extending protrusions for holding the cable therebetween in a state, in which the second bushing body is attached to the first bushing body. In this configuration, the protrusions may each have ribs provided in a holding surface of the protrusions for holding the cable.

The protrusions of the first main portion and the second main portion allow holding the cable on one side of the first metal member and the second metal member by providing grip between the cable bushing and the outer layer of the cable. Thereby, pull-out of the cable from the cable bushing along the length direction of the cable is effectively prevented.

Similarly, the protrusions of the first auxiliary portion and the second auxiliary portion allow holding the cable on the other side of the first metal member and the second metal member by providing grip to the outer layer of the cable on the other side of the first metal member and the second metal member. Thereby, pull-out of the cable from the cable bushing along the length direction of the cable is effectively prevented.

The ribs in the protrusions may be provided in the holding surface for allowing a certain degree of bending flexibility in order to securely hold the cable even when the cable is bent.

Preferably, one of the first main portion and the second main portion may have an engagement hole, and the other of the first main portion and the second main portion may have an engagement pin for engaging with the engagement hole by attaching the first bushing body to the second bushing body.

Such a configuration allows a simple design of the cable bushing and provides an effective attachment between the first bushing body and the second bushing body.

Two or more engagement holes and two or more engagement pins may be provided in the first main portion and the second main portion for allowing a more reliable engagement between the first main portion and the second main portion. Moreover, providing two or more engagement holes and two or more engagement pins allow a proper alignment of the first main portion and the second main portion such that a predetermined attachment configuration of the first main portion and the second main portion can be ensured.

The first main portion of the first bushing body and the second main portion of the second bushing body each comprise an external thread segment, which together form an external thread, when the second bushing body is attached to the first bushing body. The cable bushing further comprises a counter nut that is engageable with the external thread formed by the external thread segments, when the second bushing body is attached to the first bushing body.

By providing a counter nut, the first main portion and the second main portion are maintained together in an attached state. Thereby, a locking mechanism is provided to prevent the second bushing body from coming off from the first bushing body.

Preferably, the cable bushing may be detachably attachable in the aperture of the wall by tightening the counter nut on the external thread segments towards the first metal member.

In such a configuration, the counter nut provides a detachably attachable connection between the cable bushing and the wall. The configuration further allows the arrangement of the first metal member and the second metal member on one side of the wall and the counter next on the other side of the wall, when the cable bushing is inserted in the wall.

By tightening the counter nut on the external thread, contact pressure can be applied between the wall and the first metal member and the second metal member. Accordingly, the cable bushing is reliably fixed in the wall and the electric contact between the wall and the first metal member and the second metal member is reliably established.

Preferably, the first metal member may have a plurality of first holes and the first bushing body may further comprise a plurality of first connection portions connecting the first main portion and the first auxiliary portion through the first holes. The first main portion, the first connection portions and the first auxiliary portions may be integrally formed by molding.

Similarly, the second metal member may have a plurality of second holes and the second bushing body may further comprise a plurality of second connection portions connecting the second main portion and the second auxiliary portion through the second holes. The second main portion, the second connection portions and the second auxiliary portions may be integrally formed by molding.

The plurality of first holes and the plurality of second holes may be pre-drilled in the first metal member and the second metal member, respectively, and allow an integral connection between the first main portion and the first auxiliary portion, and the second main portion and the second auxiliary portion, respectively.

During molding of the first bushing body and the second bushing body, a molding material can flow through the plurality of first holes in the first metal member, and through the plurality of second holes in the second bushing body. Thereby, the first metal member is non-movably locked in its position between the first main portion and the first auxiliary portion, and the second metal member is non-movably locked in its position between the second main portion and the second auxiliary portion.

Preferably, four circular holes are arranged in each of the first metal member and the second metal member. However, also less than four holes, such as two holes for example, or more than four holes may be formed in each of the first metal member and the second metal member.

Preferably, the first bushing body and the second bushing body may be welded together by ultrasonic welding.

In such a configuration, the first bushing body and to second bushing body are integrally connected by ultrasonic plastic welding. Thereby, the arrangement of the first bushing body with respect to the second bushing body is fixed in its position, when the cable is placed on the first bushing body and the second bushing body is attached to the first bushing body.

The ultrasonic welding provides a durable and robust connection between the first bushing body and the second bushing body.

The object is also solved by a method of mounting a cable bushing to a cable according to claim 13. The method comprises placing the cable on the first bushing body such that an electrical connection is established between the cable shield of the cable and the first metal member, attaching the second bushing body to the first bushing body such that the cable is pressed against the first bushing body, and integrally connecting the first bushing body and the second bushing body by ultrasonic welding.

The method of mounting the cable bushing to the cable provides a reliable connection between the cable bushing and the cable. Subsequently, after the cable bushing is mounted to the cable, the cable bushing may be inserted in an aperture of a wall such that an electric connection is established between the first metal member and the wall.

In addition, a counter nut may be tightened on an external thread formed by external thread segments of the first main portion of the first bushing body and a second main portion of the second bushing body towards the first metal member.

The object is also solved by an electromagnetic shielding system according to claim 14. The electromagnetic shielding system comprises a housing for accommodating an electromagnetically transmitting and/or receiving device, configured to shield electromagnetic radiation transmitted from or to the electromagnetic transmitting and/or receiving device, and the cable bushing according to the above disclosure detachably attached in an aperture of a wall of the housing for guiding a cable through the wall of the housing.

The housing is made of a metal or a suitable synthetic or composite material, which is configured to shield electromagnetic radiation. The housing has an electrical conductivity.

According to such a configuration, the electromagnetic shielding system has a simple configuration and is capable of shielding electromagnetic radiation transmitted from or to the electromagnetically transmitting and/or receiving device, which is accommodated in the housing.

The electromagnetic shielding system may also comprise two or more cable bushings attached in respective apertures of the housing.

The electromagnetic shielding system may further comprise an electrical conductor, which is arranged inside the housing, an external antenna, which is arranged outside the housing, and a cable, which is guided through the wall of the housing via the cable bushing and coupled with one end to the electrical conductor and coupled with the other end to the external antenna.

By providing an electrical conductor inside the housing, an external antenna outside the housing and electrically connecting the electrical conductor and the external antenna by a cable guided through the wall of the housing, a wireless communication of the electromagnetic transmitting and/or receiving device can be maintained. The external antenna can be moved to a suitable position away from the housing such that a power of the electromagnetic radiation around the housing can be reduced.

The electromagnetic shielding system may further comprise a control device installed in the wall of the housing for manually operating the electromagnetic transmitting and/or receiving device from outside of the housing via a mechanical and/or electric connection.

With such a configuration, the electromagnetic transmitting and/or receiving device may be operated safely without exposing a user to electromagnetic radiation transmitted from the electromagnetic transmitting and/or receiving device.

Preferably, the housing of the electromagnetic shielding system may comprise a port for placing and/or removing the electromagnetic transmitting and/or receiving device in and/or from the housing, and a port cover detachably attachable to the port.

The port cover is configured to shield electromagnetic radiation.

Accordingly, easy maintenance of the electromagnetic transmitting and/or receiving device is allowed when the cover is detached from the port, and shielding of electromagnetic radiation is allowed when the cover is attached to the port.

The port cover of the housing of the electromagnetic shielding system may comprise an opening for permitting visual and/or functional contact with the electromagnetic transmitting and/or receiving device, and an opening cover detachably attachable to the opening.

The opening cover is configured to shield electromagnetic radiation.

Accordingly, visual and/or functional contact of the electromagnetic transmitting and/or receiving device is permitted from the outside of the housing, whereas shielding of electromagnetic radiation is effectively ensured.

### Brief description of drawings

The aspects of the disclosure may be best understood from the following detailed description taken in conjunction with the accompanying figures.

The figures are schematic and simplified for clarity, and they just show details to improve the understanding of the claims, while other details are left out. The individual features of each aspect may each be combined with any or all features of the other aspects. These and other aspects, features and/or technical effect will be apparent from and elucidated with reference to the illustrations described hereinafter, in which:
Fig. 1 is a side view of a cable bushing according to an embodiment of the disclosure in a non-attached state;
Fig. 2 is a side view of a cable bushing according to an embodiment of the disclosure in an attached state;
Fig. 3 is a top view of the first bushing body of a cable bushing according to an embodiment of the disclosure;
Fig. 4 is a schematic side view of a first bushing body of a cable bushing according to an embodiment of the disclosure in a mounted state in a wall;
Fig. 5 is a side view of the second bushing body of a cable bushing according to an embodiment of the disclosure;
Fig. 6 is a top view of a first metal member and a second metal member of a cable bushing according to an embodiment of the disclosure;
Fig. 7 is a schematic diagram of an electromagnetic shielding system comprising a cable bushing according to an embodiment of the disclosure;
Fig. 8A is a side view of a housing of the electromagnetic shielding system shown in Fig. 7; and
Fig. 8B is a side view of a modification of the housing of the electromagnetic shielding system shown in Fig. 7.

### Detailed description

The detailed description set forth below in connection with the appended drawings is intended as a description of various configurations. The detailed description includes specific details for the purpose of providing a thorough understanding of various concepts. However, it will be apparent to those skilled in the art that these concepts may be practised without these specific details.

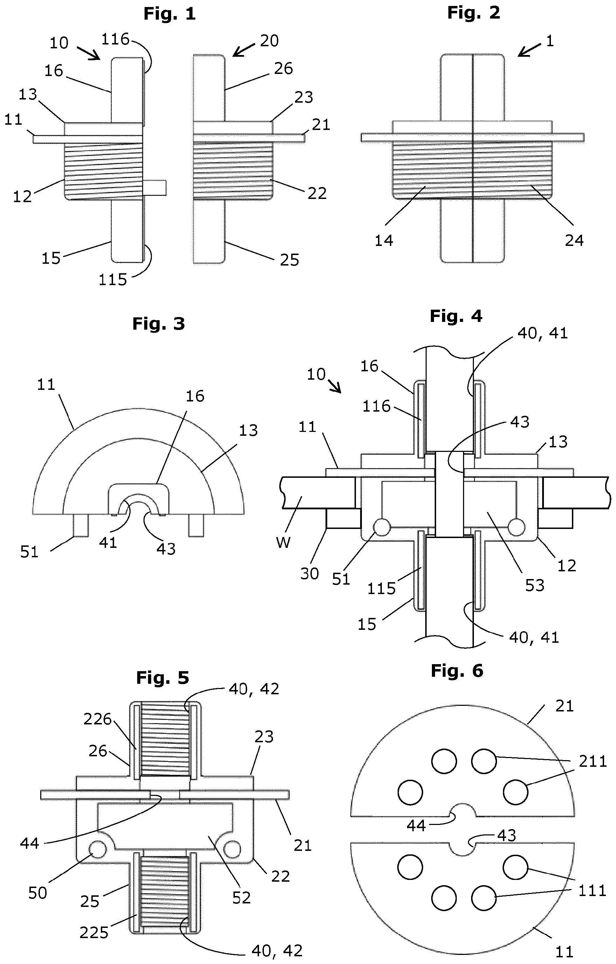

Fig. 1 is a side view of a cable bushing 1 according to an embodiment. The cable bushing 1 comprises a first bushing body 10 with a first metal member 11. Further, the cable bushing 1 comprises a second bushing body 20 with a second metal member 21. The first bushing body 10 and the second bushing body 20 can be attached to each other, as shown in Fig. 2, with a cable being guided through the assembled cable bushing 1. The first and the second metal member 11, 21 are provided at the first and second bushing bodies 10, 20 in such a manner that they can provide an electrical connection with a portion of a cable shield being exposed by removing a corresponding portion of a cable sheathing of the cable. The cable bushing 1 allows guiding the cable through a wall W of a housing or a box for electromagnetically shielding an electric device.

### First bushing body

As shown in Fig. 1, the first bushing body 10 comprises a first main portion 12 arranged on one side of the first metal member 11. The first main portion 12 is configured to be inserted into an aperture of the wall W. As shown in a side view of the first bushing body 10 in Fig. 4, the first main portion 12 has a shape, which comprises a semi-cylindrical outer peripheral surface extending along a main axis and a flat surface (parallel to the drawing plane in Fig. 4). A recess 53 is formed in the flat surface of the first main portion 12 and a remainder of the flat surface serves as a main contact surface for contacting a corresponding contact surface of the second bushing body 20. A direction of the main axis is referred to as a main axis direction. The main axis of the first bushing body 10 is located entirely in a contact plane defined by the main contact surface.

The recess 53 has a semi-cylindrical shape, whose cylinder axis is identical to the main axis of the first bushing body 10. A radius of the semi-cylindrical shape of the recess 53 is smaller than a radius of the semi-cylindrical outer peripheral surface of the first main portion 12. Accordingly, the first main portion 12 has a uniform wall thickness along the outer peripheral surface. A height of the semi-cylindrical shape of the recess 53 is smaller than a height of the semi-cylindrical shape of the first main portion 12, and the semi-cylindrical shape of the recess 53 is positioned along the main axis of the first bushing body 10, such that an upper wall and a lower wall of the first main portion 12 are formed. The upper wall of the first main portion 12 is in contact with the first metal member 11. The lower wall of the first main portion 12 is arranged on an opposite side of the recess 53 with respect to the upper wall of the first main portion 12. A thickness of the upper wall is smaller than a thickness of the lower wall, as shown in the side view of Fig. 4.

Further, a hole is formed in the upper wall and another hole is formed in the lower wall of the first main portion 12, for allowing the cable to be guided substantially along the main axis of the first bushing body 10 along the first bushing body 10. In other words, a main axis of each of the holes in the upper wall and the lower wall coincides with the main axis of the first bushing body 10.

As shown in Figs. 1, 3 and 4, the first main portion 12 of the first bushing body 10 further comprises two engagement pins 51 protruding from the main contact surface of the first main portion 12. The two engagement pins 51 extend in a direction perpendicular to the main contact surface, thereby defining an attachment direction of the first bushing body 10 and the second bushing body 20. In this embodiment, the engagement pins 51 have a substantially cylindrical shape. The engagement pins 51 may have a taper shape towards the end of the engagement pins 51 or any other shape that is suitable to be engaged with corresponding engagement holes 50 formed in the second main portion 22 of the second bushing body 20, which will be described later.

The first main portion 12 further comprises a protrusion 15 protruding from the lower wall and extending in the main axis direction, away from the first metal member 11. The protrusion 15 has a contact surface that is located entirely in the contact plane, such that the contact surface of the protrusion 15 is flush with the main contact surface of the first main portion 12.

The protrusion 15 further has a semi-cylindrical groove 41, wherein a cylinder axis of the groove 41 coincides with the main axis of the first bushing body 10. A radius of the semi-cylindrical groove 41 is larger than a radius of the cable sheathing, for providing space to accommodate the cable along the main axis of the first bushing body 10. A plurality of ribs extend from a surface of the groove 41 towards a radially inner side for contacting the cable sheathing with a tight fit. Thereby, the cable can be tightly accommodated by the ribs of the protrusion 15. End surfaces of the ribs in an extension direction from the groove 41 define a cable contact surface for contacting the cable sheathing.

Further, as shown in Figs. 1 and 4, the protrusion 15 further comprises two convex portions 115 protruding from the contact surface of the protrusion 15 in an attachment direction of the first bushing body 10 and the second bushing body 20. Each of the two convex portions 115 has an elongated shape and is disposed on one side of the groove 41 parallel to the cylinder axis of the groove 41.

As shown in Fig. 1, the first bushing body 10 further comprises a first auxiliary portion 13 arranged on another side of the first metal member 11. As shown in Figs. 3 and 4, the first auxiliary portion 13 has a shape, which comprises a semi-cylindrical outer peripheral surface extending along a main axis and a flat surface (parallel to the drawing plane of Fig. 4). A cylinder axis of the semi-cylindrical outer peripheral surface of the first auxiliary portion 13 coincides with the main axis of the first bushing body 10. Further, a hole is formed in the first auxiliary portion 13, for allowing the cable to be guided substantially along the main axis of the first bushing body 10 along the first bushing body 10. In other words, the main axis of the hole in the first auxiliary portion 13 coincides with the main axis of the first bushing body 10. A remainder of the flat surface serves as an auxiliary contact surface for contacting a corresponding contact surface of the second bushing body 20. The auxiliary contact surface is flush with the main contact surface.

Further, a length of the first auxiliary portion 13 in the main axis direction is smaller than a length of the first main portion 12 in the main axis direction.

The first auxiliary portion 13 further comprises a protrusion 16 protruding from a surface facing away from the first metal member 11, and extending in the main axis direction. The protrusion 16 has a contact surface that is located entirely in the contact plane, such that the contact surface of the protrusion 16 is flush with the auxiliary contact surface of the first auxiliary portion 13.

The protrusion 16 further has a semi-cylindrical groove 41, wherein a cylinder axis of the groove 41 coincides with the main axis of the first bushing body 10. A radius of the semi-cylindrical groove 41 is larger than a radius of the cable sheathing, for providing space to accommodate the cable substantially along the main axis of the first bushing body 10. A plurality of ribs extend from a surface of the groove 41 towards a radially inner side for contacting the cable sheathing with a tight fit. Thereby, the cable can be tightly accommodated by the ribs of the protrusion 16. End surfaces of the ribs in an extension direction from the groove 41 define a cable contact surface for contacting the cable sheathing.

Further, as shown in Figs. 1 and 4, the protrusion 16 further comprises two convex portions 116 protruding from the contact surface of the protrusion 16 in an attachment direction of the first bushing body 10 and the second bushing body 20. Each of the two convex portions 116 has an elongated shape and is disposed on one side of the groove 41 parallel to the longitudinal axis of the groove 41.

The cable contact surfaces of the protrusions 15, 16 are configured to accommodate the cable so as to guide the cable from the protrusion 16 to the protrusion 15 along the first bushing body 10.

### Second bushing body

As shown in Fig. 1, the second bushing body 20 comprises a second main portion 22 arranged on one side of the second metal member 21. The second main portion 22 is configured to be inserted into the aperture of the wall W. As shown in a side view of the second bushing body 20 in Fig. 5, the second main portion 22 has a shape, which comprises a semi-cylindrical outer peripheral surface extending along a main axis and a flat surface (parallel to the drawing plane of Fig. 5). A recess 52 is formed in the flat surface of the second main portion 22 and a remainder of the flat surface serves as a main contact surface for contacting the main contact surface of the first bushing body 10. The main axis of the second bushing body 20 is located entirely in a contact plane defined by the main contact surface.

Similar to the recess 53 shown in Fig. 4, the recess 52 has a semi-cylindrical shape, whose cylinder axis is identical to the main axis of the second bushing body 20. A radius of the semi-cylindrical shape of the recess 52 is smaller than a radius of the semi-cylindrical outer peripheral surface of the second main portion 22. Accordingly, the second main portion 22 has a uniform wall thickness along the outer peripheral surface. A height of the semi-cylindrical shape of the recess 52 is smaller than a height of the semi-cylindrical shape of the second main portion 22, and the semi-cylindrical shape of the recess 52 is positioned along the main axis of the second bushing body 20, such that an upper wall and a lower wall of the second main portion 22 are formed. The upper wall of the second main portion 22 is in contact with the second metal member 21. The lower wall of the second main portion 22 is arranged on an opposite side of the recess 52 with respect to the upper wall of the second main portion 22. A thickness of the upper wall is smaller than a thickness of the lower wall, as shown in Fig. 5.

Further, a hole is formed in the upper wall and a hole is formed in the lower wall of the second main portion 22, for allowing the cable to be guided substantially along the main axis of the second bushing body 20 along the second bushing body 20. In other words, a main axis of each of the holes in the upper wall and the lower wall coincides with the main axis of the second bushing body 20.

As shown in Fig. 5, the second main portion 22 of the second bushing body 20 further comprises two engagement holes 50 recessed from the main contact surface of the second main portion 22, and recessed in a direction perpendicular to the main contact surface (attachment direction of the first bushing body 10 and the second bushing body 20). In this embodiment, the engagement holes 50 have a substantially cylindrical shape. The engagement holes 50 may have a taper shape towards the end of the engagement holes 50 or any other shape that is suitable to be engaged with the corresponding engagement pins 51 protruding from the first main portion 12 of the first bushing body 10.

The second main portion 22 further comprises a protrusion 25 protruding from the lower wall and extending in the main axis direction, away from the second metal member 21. The protrusion 25 has a contact surface that is located entirely in the contact plane, such that the contact surface of the protrusion 25 is flush with the main contact surface of the second main portion 22.

The protrusion 25 further has a semi-cylindrical groove 42, wherein a cylinder axis of the groove 42 coincides with the main axis of the second bushing body 20. A radius of the semi-cylindrical groove 42 is larger than a radius of the cable sheathing, for providing space to accommodate the cable along the main axis of the second bushing body 20. A plurality of ribs extend from a surface of the groove 42 towards a radially inner side for contacting the cable sheathing with a tight fit. Thereby, the cable can be tightly accommodated by the ribs of the protrusion 25. Furthermore, when the first bushing body 10 is attached to the second bushing body 20, the cable is clamped between the ribs of the protrusion 25 and the ribs of the protrusion 15 of the first bushing body 10. End surfaces of the ribs in an extension direction from the groove 42 define a cable contact surface for contacting the cable sheathing.

Further, as shown in Fig. 5, the protrusion 25 further comprises two concave portions 225 protruding from the contact surface of the protrusion 25 in an attachment direction of the first bushing body 10 and the second bushing body 20. Each of the two concave portions 225 has an elongated shape and is disposed on one side of the groove 42 parallel to the cylinder axis of the groove 42. Each of the two concave portions 225 has a shape corresponding to the shape of the two convex portion 115 of the protrusion 15 of the first bushing body 10, such that the convex portions 115 can be accommodated in the concave portions 225, when the first bushing body 10 is attached to the second bushing body 20.

As shown in Fig. 1, the second bushing body 20 further comprises a second auxiliary portion 23 arranged on another side of the second metal member 21. Similar to the first auxiliary portion 13, the second auxiliary portion 23 has a shape, which comprises a semi-cylindrical outer peripheral surface and a flat surface (parallel to the drawing plane of Fig. 5). A cylinder axis of the semi-cylindrical outer peripheral surface of the second auxiliary portion 23 coincides with the main axis of the second bushing body 20. Further, a hole is formed in the second auxiliary portion 23, for allowing the cable to be guided substantially along the main axis of the second bushing body 20 along the second bushing body 20. In other words, the main axis of the hole in the second auxiliary portion 23 coincides with the main axis of the second bushing body 20. A remainder of the flat surface serves as an auxiliary contact surface for contacting the auxiliary contact surface of the first bushing body 10. The auxiliary contact surface is flush with the main contact surface.

Further, a length of the second auxiliary portion 23 in the main axis direction is smaller than a length of the second main portion 22 in the main axis direction.

The second auxiliary portion 23 further comprises a protrusion 26 protruding from a surface facing away from the second metal member 21, and extending in the main axis direction. The protrusion 26 has a contact surface that is located entirely in the contact plane, such that the flat surface of the protrusion 26 is flush with the auxiliary contact surface of the second auxiliary portion 23.

The protrusion 26 further has a semi-cylindrical groove 42, wherein a cylinder axis of the groove 42 coincides with the main axis of the second bushing body 20. A radius of the semi-cylindrical groove 42 is larger than a radius of the cable sheathing, for providing space to accommodate the cable substantially along the main axis of the second bushing body 20. A plurality of ribs extend from a surface of the groove 42 towards a radially inner side for contacting the cable sheathing with a tight fit. Thereby, the cable can be tightly accommodated by the ribs of the protrusion 26.

Furthermore, when the first bushing body 10 is attached to the second bushing body 20, the cable is clamped between the ribs of the protrusion 26 and the ribs of the protrusion 16 of the first bushing body 10. End surfaces of the ribs in an extension direction from the groove 42 define a cable contact surface for contacting the cable sheathing.

Further, as shown in Fig. 5, the protrusion 26 further comprises two concave portions 226 protruding from the contact surface of the protrusion 26 in an attachment direction of the first bushing body 10 and the second bushing body 20. Each of the two concave portions 226 has an elongated shape and is disposed on one side of the groove 42 parallel to the longitudinal axis of the groove 42. Each of the two concave portions 226 has a shape corresponding to the shape of the two convex portion 116 of the protrusion 16 of the first bushing body 10, such that the convex portions 116 can be accommodated in the concave portions 226, when the first bushing body 10 is attached to the second bushing body 20.

The cable contact surfaces 42 of the protrusions 25, 26 are configured to accommodate the cable so as to guide the cable from the protrusion 26 to the protrusion 25 along the second bushing body 20.

That is, in a state, in which the second bushing body 20 is attached to the first bushing body 10, the main axis of the first bushing body 10 coincides with the main axis of the second bushing body 20 and the cable contact surfaces of the protrusions 15, 16, 25, 26 form a through-hole 40 for guiding the cable through the bushing body 1. In other words, the cylinder axis of the semi-cylindrical grooves 41 of the protrusions 15, 16 coincide with the cylinder axis of the semi-cylindrical grooves 42 of the protrusions 25, 26. Further, the cable contact surfaces of the protrusions 15, 16, 25, 26 define a cylindrical contact surface of the through-hole 40.

As shown in Figs. 1 and 2, the first main portion 12 and second main portion 22 each further comprises external thread segments 14, 24 on their respective semi-cylindrical outer peripheral surfaces. In a state, in which the second bushing body 20 is attached to the first bushing body 10, the external thread segments 14, 24 form an external thread engageable with an internal threat of a counter nut 30, as will be described later.

### Metal member

The first metal member 11 and the second metal member 21 are disc-shaped members, which extend in a plane that is perpendicular to the main axis of the first bushing body 10 and the second bushing body 20, respectively.

The first metal member 11 has a semi-circular shape when viewed from a side in the main axis direction. The first metal member 11 has a thickness in the main axis direction.

A radius center point of the semi-circular shape of the first metal member 11 is positioned on the main axis of the first main portion 12 (the cylinder axis of the semi-cylindrical shape of the first main portion 12). In other words, the radius center point of the semi-circular shape of the first metal member 11 coincides with the cylinder axis of the semi-cylindrical shape of the first main portion 12.

That is, an outer peripheral surface of the first metal member 11 comprises a curved surface along the semi-circular shape and a flat surface connecting both ends of the curved surface. A semi-cylindrical groove 43, whose cylinder axis is positioned on the main axis of the first bushing body 10, is formed in the flat surface, and a remainder of the flat surface serves as a first metal member contact surface for contacting a corresponding contact surface of the second metal member 21, as described later. The first metal member contact surface is located entirely in the contact plane of the first bushing body 10. In other words, the first metal member contact surface of the first metal member 11 is flush to the main contact surface of the first main portion 12.

A surface of the semi-cylindrical groove 43 defines a cable shield contact surface. A radius of the semi-cylindrical groove 43 is smaller than the radius of the semi-cylindrical grooves 41 of the protrusions 15, 16 for contacting the cable shield. The first metal member 11 protrudes further towards a radially inner side than the ribs of the protrusions 15, 16 (the cable contact surfaces) with respect to the main axis of the first bushing body 10.

As shown in Fig. 6, the first metal member 11 further comprises a plurality of first holes 111 that penetrate through the first metal member 11 in the thickness direction (main axis direction). In this embodiment, there are four first holes 111 provided in the first metal member 11. The first holes 111 are positioned on a pitch semi-circle that is concentric to the radius center point of the semi-circular shape of the first metal member 11. The four first holes 111 are spaced apart from each other equally.

Further, there are four first connection portions 17 provided in the first bushing body 10, and each of the four first connections portions 17 extends through a first hole 111 of the four first holes 111. The first connection portions 17 connect the first main portion 12 to the first auxiliary portion 13 through the first metal member 11. When molding the first bushing body 10, a material of the first bushing body 10 flows through the first holes 111, thereby connecting the first main portion 12 and the first auxiliary portion 13.

Similar to the first metal member 11, the second metal member 12 has a semi-circular shape when viewed from a side in the main axis direction. The second metal member 21 has a thickness in the main axis direction that is equal to the thickness of the first metal member 11.

A radius center point of the semi-circular shape of the second metal member 21 is positioned on the main axis of the second main portion 22 (the cylinder axis of the semi-cylindrical shape of the second main portion 22). In other words, the radius center point of the semi-circular shape of the second metal member 21 coincides with the cylinder axis of the semi-cylindrical shape of the second main portion 22.

That is, an outer peripheral surface of the second metal member 21 comprises a curved surface along the semi-circular shape and a flat surface connecting both ends of the curved surface. A semi-cylindrical groove 44, whose cylinder axis is positioned on the main axis of the second bushing body 20, is formed in the flat surface, and a remainder of the flat surface serves as a second metal member contact surface for contacting the first metal member contact surface of the first metal member 11. The second metal member contact surface is located entirely in the contact plane of the second bushing body 20. In other words, the second metal member contact surface of the second metal member 21 is flush to the main contact surface of the second main portion 22.

A surface of the semi-cylindrical groove 44 defines a cable shield contact surface. A radius of the semi-cylindrical groove 44 is smaller than the radius of the semi-cylindrical grooves 42 of the protrusions 25, 26 for contacting the cable shield. The second metal member 21 protrudes further towards a radially inner side than the ribs of the protrusions 25, 26 (the cable contact surfaces) with respect to the main axis of the second bushing body 20.

As shown in Fig. 6, the second metal member 21 further comprises a plurality of second holes 211 that penetrate through the second metal member 21 in the thickness direction (main axis direction). In this embodiment, there are four second holes 211 provided in the second metal member 21. The second holes 211 are positioned on a pitch semi-circle that is concentric to the radius center point of the semi-circular shape of the second metal member 21. The four second holes 211 are spaced apart from each other equally.

Further, there are four second connection portions 27 provided in the second bushing body 20, and each of the four second connections portions 27 extends through a second hole 211 of the four second holes 211. The second connection portions 27 connect the second main portion 22 to the second auxiliary portion 23 through the second metal member 21. When molding the second bushing body 20, a material of the second bushing body 20 flows through the second holes 211, thereby connecting the second main portion 22 and the second auxiliary portion 23.

### Assembly

Fig. 2 is a side view of the cable bushing according to the embodiment of the disclosure in an attached state, in which the second bushing body 20 is attached to the first bushing body 10. That is, the second bushing body 20 is attached to the first bushing body 10 and the contact surfaces of the first bushing body 10 and the second bushing body 20 contact with each other. Accordingly, the first main portion 12 contacts the second main portion 22, the first metal member 11 contacts the second metal member 21, the first auxiliary portion 13 contacts the second auxiliary portion 23, the protrusion 15 contacts the protrusion 25, and the protrusion 16 contacts the protrusion 26, in the contact plane, respectively.

In a state, in which the second bushing body 20 is attached to the first bushing body 10, the first metal member contact surface of the first metal member 11 is brought into contact with the second metal member contact surface of the second metal member 21. Thereby, the cable shield of the cable is clamped between the grooves 43, 44 of the first metal member 11 and the second metal member 21. Accordingly, a proper electrical contact can be established between the cable shield of the cable and the first metal member 11 and the second metal member 21.

Fig. 4 shows the cable being placed on the first bushing body 10 and the first metal member 11. The cable extends along an up/down-direction of Fig. 4. The contact surfaces of the protrusions 15, 16 each contact the cable sheathing. As shown in Fig. 4, a portion of the cable sheathing (insulation layer) is stripped off so as to expose the cable shield located underneath the outer layer of the cable. The cable contact surface of the groove 43 of the first metal member 11 is configured to come into contact with the cable shield of the cable. By contacting the cable shield of the cable, an electrical connection is established between the cable shield and the first metal member 11.

Similarly, in an attached state, the contact surfaces of the protrusions 25, 26 each contact the cable sheathing and the cable contact surface of the groove 44 of the second metal member 21 is configured to come into contact with the cable shield of the cable.

Fig. 4 schematically shows a state, in which the cable bushing 1 is mounted in the wall W. For illustrating purposes, the second bushing body 20 and the second metal member 21 are not shown in Fig. 4.

The cable bushing 1 is inserted into a cylindrical aperture of the wall W by inserting the protrusions 15, 25, and then inserting the first main portion 12 and the second main portion 22. The insertion direction of the cable bushing 1 into the wall W coincides with the main axis of the first bushing body 10 and the second bushing body 20. The insertion of the cable bushing 1 is stopped, when the first bushing body 12 and the second bushing body 22 are entirely inserted into the aperture of the wall W, and the first metal member 11 and the second metal member 21 come into contact with the wall W. Thereby, the electrical contact is established between the wall W and the cable shield via each of the first metal member 11 and the second metal member 21.

Then, the counter nut 30 is engaged with the external thread formed by the external thread segment 14 of the first main portion 12, and the external thread segment 24 of the second main portion 22. The counter nut 30 is engaged to the external thread from a side of the wall W, which is opposed to the side of the wall W from which the cable bushing 1 has been inserted (a side opposed to the side of the wall W, where the first metal member 11 and the second metal member 21 come into contact with the wall W). That is, the first metal member 11 and the second metal member 21 are arranged on one side of the wall W, and the counter nut is arranged on the other side of the wall W.

Then, the counter nut 30 is tightened on the external thread in a direction towards the first metal member 11 and the second metal member 21, thereby mounting the cable bushing 1 in the aperture of the wall W so as to be non-rotatable and non-displaceable.

### Modifications

Various modifications of the cable bushing 1 are conceivable. In the embodiment, it has been described that the design and structural features of the second bushing body 20 are substantially the same as those of the first bushing body 10. It is however noted that it is also conceivable to design the second bushing body 20 in a simplified manner, without all the structural features described in the embodiment. Therein, it is particularly important that the second bushing body 10 can at least press the cable against the first bushing body 10 so as to establish an electrical connection between the cable shield and the first metal member 11. The recess 52 and the external thread segment 24 may be omitted, for example.

Further, the first holes 111 and the second holes 211 do not necessarily have to be formed in the first metal member 11 and the second metal member 21, respectively. Alternatively, the first main portion 12 and the first auxiliary portion 13 may be formed separately, and the first main portion 12 could be connected to one side of the first metal member 11 and the first auxiliary portion 13 could be connected to the other side of the first metal member 11 by an adhesive, for example. Similarly, the second main portion 22 and the second auxiliary portion 23 may be formed separately, and the second main portion 22 could be connected to one side of the second metal member 21 and the second auxiliary portion 23 could be connected to the other side of the second metal member 21 by an adhesive, for example.

### Electromagnetic shielding system

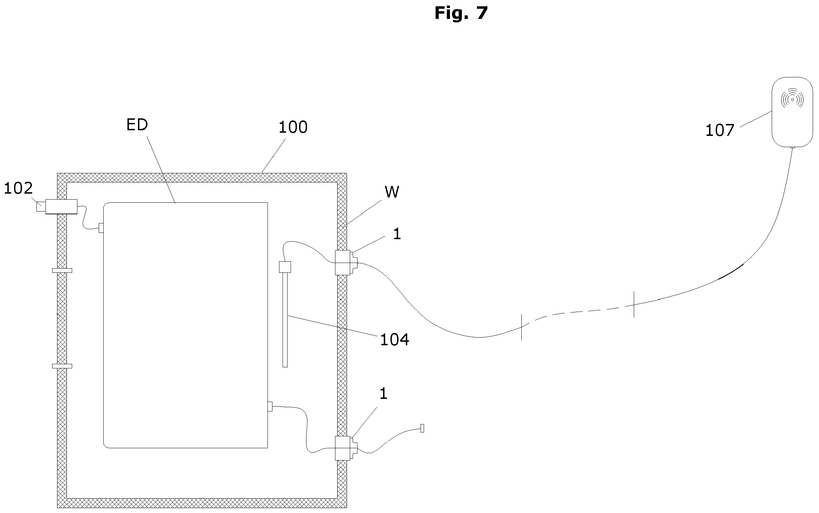

Fig. 7 is a schematic diagram of an electromagnetic shielding system which may comprise a cable bushing 1 according to an embodiment of the disclosure. The electromagnetic shielding system shown in Fig. 7 is an example for illustrating the use of the cable bushing 1 described above.

The electromagnetic shielding system comprises a housing 100, which forms the wall W, and the cable bushing 1 described above. The housing 100 is configured to accommodate an electric device ED, which is an electromagnetic transmitting and/or receiving device that transmits and/or receives electromagnetic radiation. The housing 100 is made of a material having electromagnetically shielding properties for shielding electromagnetic radiation transmitted from or to the electric device ED. Further, the housing 100 is electrically connected to the earth, thereby providing electrical grounding.

The housing 100 has a substantially cuboid shape. The housing 100 further has two housing holes (apertures) formed in the wall W. Two cable bushings 1 are inserted in the housing holes (the apertures of the wall W), respectively.

One of the two cable bushings 1 is used to guide an antenna cable through the wall W, as explained below.

The electromagnetic shielding system further comprises an electrical conductor 104 serving as an internal antenna, which is arranged inside the housing 100, and an external antenna 107, which is arranged outside the housing 100. One end of the antenna cable is coupled to the electrical conductor 104. The electrical conductor 104 is constructed in a manner as to induce the electromagnetic radiation transmitted from or to the electric device ED. From the one end of the antenna cable, the antenna cable is guided through the wall W via the one cable bushing 1. The other end of the antenna cable is coupled to the external antenna 107 outside the housing 100, which allows wireless communication of the electric device ED.

Alternatively, the other end of the antenna cable may be coupled to a connector plug leading to a central or external building antenna. The antenna cable has an appropriate length according to a requirement of a user and has a cable shield capable of shielding the electromagnetic radiation and transporting the signal in the desired frequencies along its length.

The cable shield of the antenna cable is electrically connected to the housing 100 by the one of the two cable bushings 1.

The other of the two cable bushings 1 is used to guide a charging cable through the wall W, which connects the electric device ED accommodated inside the housing 100 with an electric power source located outside the housing 100. The charging cable has an appropriate length according to a requirement of a user and has a cable shield capable of shielding the electromagnetic radiation.

The cable shield of the charging cable is electrically connected to the housing 100 by the other of the two cable bushings 1.

As shown in Fig. 7, the housing 100 further comprises a control device 102 installed in the wall W of the housing 100. The control device 102 is a control button for manually operating the electric device ED from outside of the housing 100 via a mechanical and/or electric connection. Alternatively, the control device 102 may be a control dial for manually operating the electric device ED from outside of the housing 100 via a mechanical and/or electric connection.

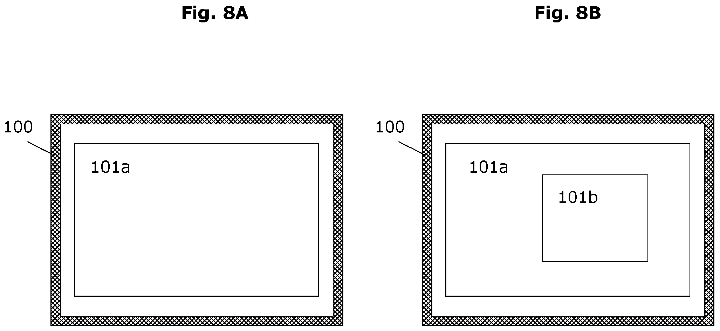

Fig. 8A is a side view of the housing 100 of the electromagnetic shielding system shown in Fig. 7. The housing 100 further comprises a port arranged on one side surface of the cuboid shape of the housing 100. The port has a rectangular shape for facilitating the placement of the electric device ED and/or for its use or adjustment. As shown in Fig. 8A, a port cover 101a is detachably attached to the port. The port cover 101a is made of a material having electromagnetically shielding properties for shielding electromagnetic radiation.

Fig. 8B is a side view of a modification of the housing 100 of the electromagnetic shielding system shown in Fig. 7. In addition to the housing 100 of the electromagnetic shielding system shown in Fig. 8A, the modification of the housing 100 further comprises a rectangular opening formed in the port cover 101a. As shown in Fig. 8B, an opening cover 101b is detachably attached to the opening. The opening cover 101b is made of a material having electromagnetically shielding properties for shielding electromagnetic radiation, and permits visual and/or functional contact with the electric device ED.

The electromagnetic shielding system described above is not limited to two housing holes and two cable bushings 1. Only one cable bushing 1 or three or more cable bushings 1 may be provided in the electromagnetic shielding system. Further, the cable bushing 1 is not limited to guiding an antenna cable and a charging cable through the wall W of the housing 100. Other types of cables, for example a cable for transmitting a control signal or a data signal through the wall W of the housing 100 may be provided.

The particular features, structures or characteristics described in the embodiment do not all have to be present in one cable bushing, and particular feature may be omitted. The previous description is provided to enable any person skilled in the art to practice the various aspects described herein. Various modifications to the embodiment will be readily apparent to those skilled in the art, and the generic principles defined herein may be applied to other aspects.

## Claims

1. A cable bushing (1) for guiding a shielded cable through a wall (W), comprising:
a first bushing body (10),
a first metal member (11) arranged in the first bushing body (10),
a second bushing body (20), and
a second metal member (21) arranged in the second bushing body (20), wherein
the first bushing body (10) and the second bushing body (20) are made from a non-metal material,
the first bushing body (10) comprises a first main portion (12) and a first auxiliary portion (13) arranged on an opposite side of the first metal member (11) with respect to the first main portion (12), for holding the first metal member (11) therebetween, and
the second bushing body (20) comprises a second main portion (22) and a second auxiliary portion (23) arranged on an opposite side of the second metal member (21) with respect to the second main portion (22), for holding the second metal member (21) therebetween,
the first metal member (11) is suitable for establishing an electrical connection between a cable shield of the cable and the wall (W), and
the second metal member (21) is suitable for establishing an electrical connection between the cable shield of the cable and the wall (W), **characterized in that**
the second bushing body (20) is attachable to the first bushing body (10) for pressing the cable against the first bushing body (10), and
the first main portion (12) of the first bushing body (10) and the second main portion (22) of the second bushing body (20) each comprise an external thread segment (14, 24), and
the cable bushing (1) further comprises a counter nut (30) that is engageable with the external thread segments (14, 24) in a state, in which the second bushing body (20) is attached to the first bushing body (10).

2. A cable bushing (1) according to claim 1, wherein
the second metal member (21) is electrically connectable to the first metal member (11) by attaching the first bushing body (10) to the second bushing body (20).

3. A cable bushing (1) according to claim 1 or 2, wherein
in a state, in which the second bushing body (20) is attached to the first bushing body (10), a through-hole (40) for guiding the cable through the wall (W) is provided in the first bushing body (10) and the second bushing body (20) along a contact plane of the first bushing body (10) and the second bushing body (20), and
the first metal member (11) and the second metal member (21) protrude into the through-hole (40) for establishing an electrical connection with the cable shield.

4. A cable bushing (1) according to any one of claims 1 to 3, wherein the cable bushing (1) is configured to clamp the cable between the first bushing body (10) and the second bushing body (20) by attaching the first bushing body (10) to the second bushing body (20).

5. A cable bushing (1) according to any one of claims 1 to 4, wherein
the first main portion (12) and the second main portion (22) each have a semi-cylindrical shape,
the first metal member (11) and the second metal member (21) each have a semi-circular disc shape,
the first metal member (11) is arranged in the first bushing body (10) such that a radius center point of the semi-circular shape of the first metal member (11) is positioned on the cylinder axis of the semi-cylindrical shape of the first main portion (12), and
the second metal member (21) is arranged in the second bushing body (20) such that a radius center point of the semi-circular shape of the second metal member (21) is positioned on the cylinder axis of the semi-cylindrical shape of the second main portion (22).

6. A cable bushing (1) according to claim 5, wherein
the semi-circular shape of the first metal member (11) has an outer radius larger than an outer radius of the semi-cylindrical shape of the first main portion (12) of the first bushing body (10), and
the semi-circular shape of the second metal member (21) has an outer radius larger than an outer radius of the semi-cylindrical shape of the second main portion (22) of the second bushing body (20).

7. A cable bushing (1) according to any one of claims 1 to 6, wherein
the first main portion (12) has a recess (53) on a surface facing the second main portion (22) in an attachment direction of the first bushing body (10) and the second bushing body (20), and
the second main portion (22) has a recess (52) on a surface facing the first main portion (12) in an attachment direction of the first bushing body (10) and the second bushing body (20).

8. A cable bushing (1) according to any one of claims 1 to 7, wherein
the first main portion (12) and the second main portion (22) each have protrusions (15, 25) for holding the cable therebetween in a state, in which the second bushing body (20) is attached to the first bushing body (10),
the first auxiliary portion (13) and the second auxiliary portion (23) each have protrusions (16, 26) for holding the cable therebetween in a state, in which the second bushing body (20) is attached to the first bushing body (10), and
the protrusions (15, 16, 25, 26) each have ribs provided in a holding surface for holding the cable.

9. A cable bushing (1) according to any one of claims 1 to 8, wherein
one of the first main portion (12) and the second main portion (22) has an engagement hole (50), and
the other of the first main portion (12) and the second main portion (22) has an engagement pin (51) for engaging with the engagement hole (50) by attaching the first bushing body (10) to the second bushing body (20).

10. A cable bushing (1) according to any one of claims 1 to 9, wherein the cable bushing (1) is detachably attachable in an aperture of the wall (W) by tightening the counter nut (30) on the external thread segments (14, 24) towards the first metal member (11).

11. A cable bushing (1) according to any one of claims 1 to 10, wherein
the first metal member (11) has a plurality of first holes (111) and the first bushing body (10) further comprises a plurality of first connection portions (17) connecting the first main portion (12) and the first auxiliary portion (13) through the first holes (111),
the first main portion (12), the first connection portions (17) and the first auxiliary portions (13) are integrally formed by molding,
the second metal member (21) has a plurality of second holes (211) and the second bushing body (20) further comprises a plurality of second connection portions (27) connecting the second main portion (22) and the second auxiliary portion (23) through the second holes (211), and
the second main portion (22), the second connection portions (27) and the second auxiliary portions (23) are integrally formed by molding.

12. A cable bushing (1) according to any one of claims 1 to 11, wherein
the first bushing body (10) and the second bushing body (20) are welded together by ultrasonic welding.

13. A method of mounting a cable bushing according to any one of claims 1 to 12 to a cable, comprising:
placing the cable on the first bushing body (10) such that an electrical connection is established between the cable shield of the cable and the first metal member (11),
attaching the second bushing body (20) to the first bushing body (10) such that the cable is pressed against the first bushing body (10), and
integrally connecting the first bushing body (10) and the second bushing body (20) by ultrasonic welding.

14. An electromagnetic shielding system comprising
a housing (100) for accommodating an electromagnetically transmitting and/or receiving device (ED), configured to shield electromagnetic radiation transmitted from or to the electromagnetic transmitting and/or receiving device (ED), and
a cable bushing (1) according to any one of claims 1 to 12, detachably attached in an aperture of a wall (W) of the housing (100) for guiding a cable through the wall (W) of the housing (100).

15. An electromagnetic shielding system according to claim 14, further comprising
an electrical conductor (104), which is arranged inside the housing (100),
an external antenna (107), which is arranged outside the housing (100), and
a cable, which is guided through the wall (W) of the housing (100) via the cable bushing (1) and coupled with one end to the electrical conductor (104) and coupled with the other end to the external antenna (107).

16. An electromagnetic shielding system according to claim 14 or 15, further comprising
a control device (102) installed in the wall (W) of the housing (100) for manually operating the electromagnetic transmitting and/or receiving device (ED) from outside of the housing (100) via a mechanical and/or electric connection.

17. An electromagnetic shielding system according to any one of claims 14 to 16, wherein the housing (100) further comprises
a port for placing and/or removing the electromagnetic transmitting and/or receiving device (ED) in and/or from the housing (100), and
a port cover (101a) detachably attachable to the port.

18. An electromagnetic shielding system according to any one of claims 14 to 17, wherein the port cover (101a) of the housing (100) further comprises
an opening for permitting visual and/or functional contact with the electromagnetic transmitting and/or receiving device (ED), and
an opening cover (101b) detachably attachable to the opening.

## Patentansprüche

1. Kabelbuchse (1) zum Führen eines abgeschirmten Kabels durch eine Wand (W), mit:
einem ersten Buchsenkörper (10),
einem ersten Metallelement (11), das in dem ersten Buchsenkörper (10) angeordnet ist,
einem zweiten Buchsenkörper (20) und
einem zweiten Metallelement (21), das in dem zweiten Buchsenkörper (20) angeordnet ist, wobei
der erste Buchsenkörper (10) und der zweite Buchsenkörper (20) aus einem nichtmetallischen Material gemacht sind,
der erste Buchsenkörper (10) einen ersten Hauptabschnitt (12) und einen ersten Hilfsabschnitt (13), der bezüglich des ersten Hauptabschnitts (12) auf einer entgegengesetzten Seite des ersten Metallelements (11) angeordnet ist, zum Halten des ersten Metallelements (11) dazwischen aufweist, und
der zweite Buchsenkörper (20) einen zweiten Hauptabschnitt (22) und einen zweiten Hilfsabschnitt (23), der bezüglich des zweiten Hauptabschnitts (22) auf einer entgegensetzten Seite des zweiten Metallelements (21) angeordnet ist, zum Halten des zweiten Metallelements (21) dazwischen aufweist,
das erste Metallelement (11) zum Herstellen einer elektrischen Verbindung zwischen einer Kabelabschirmung des Kabels und der Wand (W) geeignet ist und
das zweite Metallelement (21) zum Herstellen einer elektrischen Verbindung zwischen der Kabelabschirmung des Kabels und der Wand (W) geeignet ist, **dadurch gekennzeichnet, dass**
der zweite Buchsenkörper (20) zum Pressen des Kabels gegen den ersten Buchsenkörper (10) an dem ersten Buchsenkörper (10) anbringbar ist und
der erste Hauptabschnitt (12) des ersten Buchsenkörpers (10) und der zweite Hauptabschnitt (22) des zweiten Buchsenkörpers (20) jeweils ein Außengewindesegment (14, 24) aufweisen und
die Kabelbuchse (1) ferner eine Kontermutter (30) aufweist, die mit den Außengewindesegmenten (14, 24) in einem Zustand, in welchem der zweite Buchsenkörper (20) an dem ersten Buchsenkörper (10) angebracht ist, in Eingriff bringbar ist.

2. Kabelbuchse (1) nach Anspruch 1, wobei
das zweite Metallelement (21) mit dem ersten Metallelement (11) elektrisch verbindbar ist, indem der erste Buchsenkörper (10) an dem zweiten Buchsenkörper (20) angebracht wird.

3. Kabelbuchse (1) nach Anspruch 1 oder 2, wobei
in einem Zustand, in welchem der zweite Buchsenkörper (20) an dem ersten Buchsenkörper (10) angebracht ist, ein Durchgangsloch (40) zum Führen des Kabels durch die Wand (W) in dem ersten Buchsenkörper (10) und dem zweiten Buchsenkörper (20) entlang einer Kontaktebene des ersten Buchsenkörpers (10) und des zweiten Buchsenkörpers (20) vorgesehen ist und
das erste Metallelement (11) und das zweite Metallelement (21) zum Herstellen einer elektrischen Verbindung mit der Kabelabschirmung in das Durchgangsloch (40) vorstehen.

4. Kabelbuchse (1) nach einem der Ansprüche 1 bis 3, wobei die Kabelbuchse (1) konfiguriert ist, das Kabel zwischen dem ersten Buchsenkörper (10) und dem zweiten Buchsenkörper (20) zu klemmen, indem der erste Buchsenkörper (10) an dem zweiten Buchsenkörper (20) angebracht wird.

5. Kabelbuchse (1) nach einem der Ansprüche 1 bis 4, wobei
der erste Hauptabschnitt (12) und der zweite Hauptabschnitt (22) jeweils eine Halbzylinderform haben,
das erste Metallelement (11) und das zweite Metallelement (21) jeweils eine halbkreisartige Scheibenform haben,
das erste Metallelement (11) in dem ersten Buchsenkörper (10) so angeordnet ist, dass ein Radiusmittelpunkt der halbkreisartigen Form des ersten Metallelements (11) auf der Zylinderachse der Halbzylinderform des ersten Hauptabschnitts (12) positioniert ist, und
das zweite Metallelement (21) in dem zweiten Buchsenkörper (20) so angeordnet ist, dass ein Radiusmittelpunkt der halbkreisartigen Form des zweiten Metallelements (21) auf der Zylinderachse der Halbzylinderform des zweiten Hauptabschnitts (22) positioniert ist.

6. Kabelbuchse (1) nach Anspruch 5, wobei
die halbkreisartige Form des ersten Metallelements (11) einen äußeren Radius hat, der größer als ein äußerer Radius der Halbzylinderform des ersten Hauptabschnitts (12) des ersten Buchsenkörpers (10) ist, und
die halbkreisartige Form des zweiten Metallelements (21) einen äußeren Radius hat, der größer als ein äußerer Radius der Halbzylinderform des zweiten Hauptabschnitts (22) des zweiten Buchsenkörpers (20) ist.

7. Kabelbuchse (1) nach einem der Ansprüche 1 bis 6, wobei
der erste Hauptabschnitt (12) an einer Fläche, die dem zweiten Hauptabschnitt (22) in einer Anbringungsrichtung des ersten Buchsenkörpers (10) und des zweiten Buchsenkörpers (20) zugewandt ist, eine Aussparung (53) hat und
der zweite Hauptabschnitt (22) an einer Fläche, die dem ersten Hauptabschnitt (12) in einer Anbringungsrichtung des ersten Buchsenkörpers (10) und des zweiten Buchsenkörpers (20) zugewandt ist, eine Aussparung (52) hat.

8. Kabelbuchse (1) nach einem der Ansprüche 1 bis 7, wobei
der erste Hauptabschnitt (12) und der zweite Hauptabschnitt (22) jeweils Vorsprünge (15, 25) zum Halten des Kabels dazwischen in einem Zustand, in welchem der zweite Buchsenkörper (20) an dem ersten Buchsenkörper (10) angebracht ist, haben,
der erste Hilfsabschnitt (13) und der zweite Hilfsabschnitt (23) jeweils Vorsprünge (16, 26) zum Halten des Kabels dazwischen in einem Zustand, in welchem der zweite Buchsenkörper (20) an dem ersten Buchsenkörper (10) angebracht ist, haben und
die Vorsprünge (15, 16, 25, 26) jeweils Rippen haben, die bei einer Haltefläche zum Halten des Kabels vorgesehen sind.

9. Kabelbuchse (1) nach einem der Ansprüche 1 bis 8, wobei
einer des ersten Hauptabschnitts (12) und des zweiten Hauptabschnitts (22) ein Eingriffsloch (50) hat und
der andere des ersten Hauptabschnitts (12) und des zweiten Hauptabschnitts (22) einen Eingriffsstift (51) zum Ineingriffbringen mit dem Eingriffsloch (50) hat, indem der erste Buchsenkörper (10) an dem zweiten Buchsenkörper (20) angebracht wird.

10. Kabelbuchse (1) nach einem der Ansprüche 1 bis 9, wobei die Kabelbuchse (1) in einer Öffnung der Wand (W) lösbar anbringbar ist, indem die Kontermutter (30) an den Außengewindesegmenten (14, 24) in Richtung des ersten Metallelements (11) angezogen wird.

11. Kabelbuchse (1) nach einem der Ansprüche 1 bis 10, wobei
das erste Metallelement (11) eine Vielzahl von ersten Löchern (111) hat und der erste Buchsenkörper (10) ferner eine Vielzahl von ersten Verbindungsabschnitten (17) hat, die den ersten Hauptabschnitt (12) und den ersten Hilfsabschnitt (13) durch die ersten Löcher (111) verbinden,
der erste Hauptabschnitt (12), die ersten Verbindungsabschnitte (17) und die ersten Hilfsabschnitte (13) durch Gießen einstückig ausgebildet sind,
das zweite Metallelement (21) eine Vielzahl von zweiten Löchern (211) hat und der zweite Buchsenkörper (20) ferner eine Vielzahl von zweiten Verbindungsabschnitten (27) aufweist, die den zweiten Hauptabschnitt (22) und den zweiten Hilfsabschnitt (23) durch die zweiten Löcher (211) verbinden, und
der zweite Hauptabschnitt (22), die zweiten Verbindungsabschnitte (27) und die zweiten Hilfsabschnitte (23) durch Gießen einstückig ausgebildet sind.

12. Kabelbuchse (1) nach einem der Ansprüche 1 bis 11, wobei
der erste Buchsenkörper (10) und der zweite Buchsenkörper (20) durch Ultraschallschweißen zusammengeschweißt sind.

13. Verfahren zum Montieren einer Kabelbuchse nach einem der Ansprüche 1 bis 12 an einem Kabel, mit:
Platzieren des Kabels an dem ersten Buchsenkörper (10), sodass eine elektrische Verbindung zwischen der Kabelabschirmung des Kabels und dem ersten Metallelement (11) hergestellt wird,
Anbringen des zweiten Buchsenkörpers (20) an dem ersten Buchsenkörper (10), sodass das Kabel gegen den ersten Buchsenkörper (10) gepresst wird, und
einstückiges Verbinden des ersten Buchsenkörpers (10) und des zweiten Buchsenkörpers (20) durch Ultraschallschweißen.

14. Elektromagnetisches Abschirmungssystem mit
einem Gehäuse (100) zum Aufnehmen einer elektromagnetischen Sende- und/oder Empfangsvorrichtung (ED), das konfiguriert ist, elektromagnetische Strahlung, die von oder zu der elektromagnetischen Sende- und/oder Empfangsvorrichtung (ED) gesendet wird, abzuschirmen, und
einer Kabelbuchse (1) nach einem der Ansprüche 1 bis 12, die zum Führen eines Kabels durch die Wand (W) des Gehäuses (100) lösbar in einer Öffnung einer Wand (W) des Gehäuses (100) angebracht ist.

15. Elektromagnetisches Abschirmungssystem nach Anspruch 14, ferner mit
einem elektrischen Leiter (104), welcher innerhalb des Gehäuses (100) angeordnet ist,
einer externen Antenne (107), welche außerhalb des Gehäuses (100) angeordnet ist, und
einem Kabel, welches über die Kabelbuchse (1) durch die Wand (W) des Gehäuses (100) geführt ist und mit einem Ende an den elektrischen Leiter (104) gekoppelt ist und mit dem anderen Ende an die externe Antenne (107) gekoppelt ist.

16. Elektromagnetisches Abschirmungssystem nach Anspruch 14 oder 15, ferner mit
einer Steuerungsvorrichtung (102), die zum manuellen Betreiben der elektromagnetischen Sende- und/oder Empfangsvorrichtung (ED) über eine mechanische und/oder elektrische Verbindung von einer Außenseite des Gehäuses (100) in der Wand (W) des Gehäuses (100) installiert ist.

17. Elektromagnetisches Abschirmungssystem nach einem der Ansprüche 14 bis 16, wobei das Gehäuse (100) ferner
eine Schnittstelle zum Platzieren und/oder Entfernen der elektromagnetischen Sende- und/oder Empfangsvorrichtung (ED) in und/oder aus dem Gehäuse (100) und
eine Schnittstellenabdeckung (101a) aufweist, die an der Schnittstelle lösbar anbringbar ist.

18. Elektromagnetisches Abschirmungssystem nach einem der Ansprüche 14 bis 17, wobei die Schnittstellenabdeckung (101a) des Gehäuses (100) ferner
eine Öffnung zum Ermöglichen eines visuellen und/oder funktionalen Kontakts mit der elektromagnetischen Sende- und/oder Empfangsvorrichtung (ED) und
eine Öffnungsabdeckung (101b) aufweist, die an der Öffnung lösbar anbringbar ist.

## Revendications

1. Traversée de câble (1) destinée à guider un câble blindé à travers une paroi (W), comprenant :
un premier corps de traversée (10),
un premier élément métallique (11) agencé dans le premier corps de traversée (10),
un second corps de traversée (20), et
un second élément métallique (21) agencé dans le second corps de traversée (20), dans laquelle
le premier corps de traversée (10) et le second corps de traversée (20) sont faits d'un matériau non métallique,
le premier corps de traversée (10) comprend une première partie principale (12) et une première partie auxiliaire (13), agencée sur un côté opposé du premier élément métallique (11) par rapport à la première partie principale (12), pour retenir le premier élément métallique (11) entre celles-ci, et
le second corps de traversée (20) comprend une seconde partie principale (22) et une seconde partie auxiliaire (23), agencée sur un côté opposé du second élément métallique (21) par rapport à la seconde partie principale (22), pour retenir le second élément métallique (21) entre celles-ci,
le premier élément métallique (11) est approprié pour établir un raccord électrique entre un blindage de câble du câble et la paroi (W), et
le second élément métallique (21) est approprié pour établir un raccord électrique entre le blindage de câble du câble et la paroi (W), **caractérisée en ce que**
le second corps de traversée (20) est attachable au premier corps de traversée (10) pour presser le câble contre le premier corps de traversée (10), et
la première partie principale (12) du premier corps de traversée (10) et la seconde partie principale (22) du second corps de traversée (20) comprennent chacune un segment à filet externe (14, 24), et
la traversée de câble (1) comprend en outre un contre-écrou (30) qui peut entrer en prise avec les segments à filet externe (14, 24) dans un état où le second corps de traversée (20) est attaché au premier corps de traversée (10).

2. Traversée de câble (1) selon la revendication 1, dans laquelle
le second élément métallique (21) est électriquement raccordable au premier élément métallique (11) en attachant le premier corps de traversée (10) au second corps de traversée (20).

3. Traversée de câble (1) selon la revendication 1 ou 2, dans laquelle
dans un état où le second corps de traversée (20) est attaché au premier corps de traversée (10), un trou débouchant (40) destiné à guider le câble à travers la paroi (W) est prévu dans le premier corps de traversée (10) et le second corps de traversée (20) le long d'un plan de contact du premier corps de traversée (10) et du second corps de traversée (20), et
le premier élément métallique (11) et le second élément métallique (21) font saillie dans le trou débouchant (40) pour établir un raccord électrique au blindage de câble.

4. Traversée de câble (1) selon l'une quelconque des revendications 1 à 3, dans laquelle la traversée de câble (1) est configurée pour serrer le câble entre le premier corps de traversée (10) et le second corps de traversée (20) en attachant le premier corps de traversée (10) au second corps de traversée (20).

5. Traversée de câble (1) selon l'une quelconque des revendications 1 à 4, dans laquelle
la première partie principale (12) et la seconde partie principale (22) ont chacune une forme semi-cylindrique,
le premier élément métallique (11) et le second élément métallique (21) ont chacun une forme de disque semi-circulaire,
le premier élément métallique (11) est agencé dans le premier corps de traversée (10) de telle sorte qu'un point central de rayon de la forme semi-circulaire du premier élément métallique (11) soit positionné sur l'axe de cylindre de la forme semi-cylindrique de la première partie principale (12), et
le second élément métallique (21) est agencé dans le second corps de traversée (20) de telle sorte qu'un point central de rayon de la forme semi-circulaire du second élément métallique (21) soit positionné sur l'axe de cylindre de la forme semi-cylindrique de la seconde partie principale (22).

6. Traversée de câble (1) selon la revendication 5, dans laquelle
la forme semi-circulaire du premier élément métallique (11) a un rayon extérieur plus grand qu'un rayon extérieur de la forme semi-cylindrique de la première partie principale (12) du premier corps de traversée (10), et
la forme semi-circulaire du second élément métallique (21) a un rayon extérieur plus grand qu'un rayon extérieur de la forme semi-cylindrique de la seconde partie principale (22) du second corps de traversée (20).

7. Traversée de câble (1) selon l'une quelconque des revendications 1 à 6, dans laquelle
la première partie principale (12) a un évidement (53) sur une surface faisant face à la seconde partie principale (22) dans une direction d'attache du premier corps de traversée (10) et du second corps de traversée (20), et
la seconde partie principale (22) a un évidement (52) sur une surface faisant face à la première partie principale (12) dans une direction d'attache du premier corps de traversée (10) et du second corps de traversée (20).

8. Traversée de câble (1) selon l'une quelconque des revendications 1 à 7, dans laquelle
la première partie principale (12) et la seconde partie principale (22) ont chacune des saillies (15, 25) destinées à retenir le câble entre celles-ci dans un état où le second corps de traversée (20) est attaché au premier corps de traversée (10),
la première partie auxiliaire (13) et la seconde partie auxiliaire (23) ont chacune des saillies (16, 26) destinées à retenir le câble entre celles-ci dans un état où le second corps de traversée (20) est attaché au premier corps de traversée (10), et
les saillies (15, 16, 25, 26) ont chacune des nervures prévues dans une surface de retenue pour retenir le câble.

9. Traversée de câble (1) selon l'une quelconque des revendications 1 à 8, dans laquelle
une de la première partie principale (12) et de la seconde partie principale (22) a un trou d'entrée en prise (50), et
l'autre de la première partie principale (12) et de la seconde partie principale (22) a une goupille d'entrée en prise (51) destinée à entrer en prise avec le trou d'entrée en prise (50) en attachant le premier corps de traversée (10) au second corps de traversée (20).

10. Traversée de câble (1) selon l'une quelconque des revendications 1 à 9, dans laquelle la traversée de câble (1) est attachable de façon détachable dans une ouverture de la paroi (W) en resserrant le contre-écrou (30) sur les segments à filet externe (14, 24) vers le premier élément métallique (11).

11. Traversée de câble (1) selon l'une quelconque des revendications 1 à 10, dans laquelle
le premier élément métallique (11) a une pluralité de premiers trous (111) et le premier corps de traversée (10) comprend en outre une pluralité de premières parties de raccordement (17) raccordant la première partie principale (12) et la première partie auxiliaire (13) à travers les premiers trous (111),
la première partie principale (12), les premières parties de raccordement (17) et les premières parties auxiliaires (13) sont formées de façon monobloc par moulage,
le second élément métallique (21) a une pluralité de seconds trous (211) et le second corps de traversée (20) comprend en outre une pluralité de secondes parties de raccordement (27) raccordant la seconde partie principale (22) et la seconde partie auxiliaire (23) à travers les seconds trous (211), et
la seconde partie principale (22), les secondes parties de raccordement (27) et les secondes parties auxiliaires (23) sont formées de façon monobloc par moulage.

12. Traversée de câble (1) selon l'une quelconque des revendications 1 à 11, dans laquelle le premier corps de traversée (10) et le second corps de traversée (20) sont soudés ensemble par soudage ultrasonique.

13. Procédé de montage d'une traversée de câble selon l'une quelconque des revendications 1 à 12 sur un câble, comprenant :
le placement du câble sur le premier corps de traversée (10) de telle sorte qu'un raccord électrique soit établi entre le blindage de câble du câble et le premier élément métallique (11),
l'attache du second corps de traversée (20) au premier corps de traversée (10) de telle sorte que le câble soit pressé contre le premier corps de traversée (10), et
le raccordement monobloc du premier corps de traversée (10) et du second corps de traversée (20) par soudage ultrasonique.

14. Système de blindage électromagnétique, comprenant
un boîtier (100) destiné à loger un dispositif de transmission et/ou de réception électromagnétique (ED), configuré pour blinder un rayonnement électromagnétique transmis à partir du, ou au, dispositif de transmission et/ou de réception électromagnétique (ED), et
une traversée de câble (1) selon l'une quelconque des revendications 1 à 12, attachée de façon détachable dans une ouverture d'une paroi (W) du boîtier (100) pour guider un câble à travers la paroi (W) du boîtier (100).

15. Système de blindage électromagnétique selon la revendication 14, comprenant en outre
un conducteur électrique (104), qui est agencé à l'intérieur du boîtier (100),
une antenne externe (107), qui est agencée à l'extérieur du boîtier (100), et
un câble, qui est guidé à travers la paroi (W) du boîtier (100) par l'intermédiaire de la traversée de câble (1) et couplé, avec une extrémité, au conducteur électrique (104) et couplé, avec l'autre extrémité, à l'antenne externe (107).

16. Système de blindage électromagnétique selon la revendication 14 ou 15, comprenant en outre
un dispositif de commande (102) installé dans la paroi (W) du boîtier (100) pour mettre manuellement en fonctionnement le dispositif de transmission et/ou de réception électromagnétique (ED) depuis l'extérieur du boîtier (100) par l'intermédiaire d'un raccord mécanique et/ou électrique.

17. Système de blindage électromagnétique selon l'une quelconque des revendications 14 à 16, dans lequel le boîtier (100) comprend en outre
un orifice pour placer et/ou enlever le dispositif de transmission et/ou de réception électromagnétique (ED) dans le, et/ou à partir du, boîtier (100), et
un couvercle d'orifice (101a) attachable de façon détachable à l'orifice.

18. Système de blindage électromagnétique selon l'une quelconque des revendications 14 à 17, dans lequel le couvercle d'orifice (101a) du boîtier (100) comprend en outre
une fenêtre pour permettre le contact visuel et/ou fonctionnel avec le dispositif de transmission et/ou de réception électromagnétique (ED), et
un couvercle de fenêtre (101b) attachable de façon détachable à la fenêtre.
